(19) **Europäisches Patentamt / European Patent Office / Office européen des brevets**

(11) **EP 1 659 686 B1**

(12) **FASCICULE DE BREVET EUROPEEN**

(45) Date de publication et mention
de la délivrance du brevet:
**09.01.2008 Bulletin 2008/02**

(51) Int Cl.:
***H03H 7/42*** *(2006.01)*

(21) Numéro de dépôt: **05110920.5**

(22) Date de dépôt: **18.11.2005**

(54) **Balun à éléments localisés**

Balun mit diskreten Bauelementen

Lumped element Balun

(84) Etats contractants désignés:
**FR GB**

(30) Priorité: **18.11.2004 FR 0452678**

(43) Date de publication de la demande:
**24.05.2006 Bulletin 2006/21**

(73) Titulaire: **ST MICROELECTRONICS S.A.**
**92120 Montrouge (FR)**

(72) Inventeur: **Ezzeddine, Hilal**
**37000 Tours (FR)**

(74) Mandataire: **de Beaumont, Michel et al**
**1bis, rue Champollion**
**38000 Grenoble (FR)**

(56) Documents cités:
**US-A- 5 023 576       US-A- 6 052 039**
**US-A1- 2003 137 383**

- **PATENT ABSTRACTS OF JAPAN vol. 013, no. 280 (E-779), 27 juin 1989 (1989-06-27) -& JP 01 065904 A (MATSUSHITA ELECTRIC IND CO LTD), 13 mars 1989 (1989-03-13)**

Printed by Jouve, 75001 PARIS (FR)

**Description**

Domaine de l'invention

La présente invention concerne le domaine des transformateurs à changement de mode qui sont utilisés pour convertir une tension de mode commun en mode différentiel et inversement. De tels transformateurs sont généralement appelés "balun", de l'anglais "balanced-unbalanced". On parle aussi de transformateurs entre un mode différentiel et un mode non différentiel.

Un exemple d'application d'un transformateur à changement de mode concerne les chaînes d'émission-réception radio fréquence, par exemple, de téléphone mobile. Ce genre d'application a couramment recours à des dispositifs de type balun dans la mesure où, côté antenne, il s'agit le plus souvent d'un dispositif à une seule extrémité.

On connaît essentiellement deux catégories de transformateurs à changement de mode, à savoir des baluns à lignes couplées, dits distribués, et des baluns à éléments localisés. Les baluns à lignes couplées sont constitués de pistes conductrices couplées l'une à l'autre, la fréquence de fonctionnement du transformateur étant conditionnée par la longueur des lignes. Les baluns à éléments localisés sont constitués d'éléments capacitifs et inductifs constituant des cellules LC.

La présente invention concerne les baluns à éléments localisés qui sont généralement destinés à des applications faible bande, c'est-à-dire pour lesquelles la bande de fréquences de fonctionnement correcte du transformateur est au plus de l'ordre de 100 Mhz.

Exposé de l'art antérieur

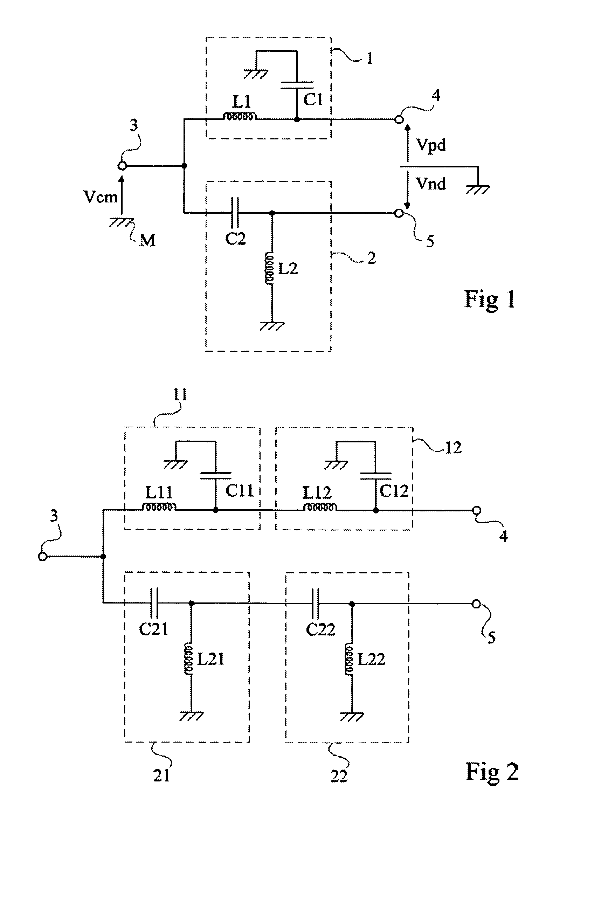

La figure 1 représente le schéma électrique d'un balun classique à éléments localisés. Un tel transformateur est essentiellement constitué d'une première cellule LC 1 reliant un accès ou borne 3 de mode commun à une première borne ou accès 4 de mode différentiel, et d'une deuxième cellule LC 2 reliant la borne de mode commun 3 à une deuxième borne 5 de mode différentiel. La borne 3 est destinée, par exemple, à recevoir un signal de mode commun Vcm provenant d'une connexion à une antenne. Ce signal est référencé à la masse M de l'équipement comprenant le transformateur à changement de mode. Le signal est partagé entre les entrée-sortie différentielles 4 et 5 qui fournissent des signaux idéalement déphasés de 180° l'un par rapport à l'autre. On peut définir arbitrairement la borne 4 comme étant positive par rapport à la masse M (tension Vpd) et la borne 5 comme étant la borne négative (tension Vnd). La masse côté mode différentiel est généralement la même que la masse de la tension de mode commun Vcm. Toutefois, ces masses peuvent être différentes l'une de l'autre notamment en cas d'isolement galvanique.

Dans l'exemple représenté, la première cellule 1 est constituée d'une inductance L1 reliant la borne 3 à la borne 4 et d'un condensateur C1 reliant la borne 4 à la masse. La deuxième cellule 2 est inversée par rapport à la première et est donc constituée d'un condensateur C2 reliant la borne 3 à la borne 5 et d'une inductance L2 reliant la borne 5 à la masse. La cellule 1 correspond en fait à une cellule de filtrage passe-bas alors que la cellule 2 correspond à une cellule de filtrage passe haut. Ces filtres passe haut 2 et passe bas 1 sont dimensionnés pour avoir une même fréquence de coupure qui correspond à la fréquence centrale de la bande de fonctionnement du transformateur.

La structure de balun illustrée par la figure 1 peut être complétée par des circuits de fixation d'une composante continue côté différentiel. Celle-ci est alors fournie par deux sources de tension distinctes et reliées par des inductances respectives non représentées (selfs de choc) aux bornes 4 et 5. Le rôle de ces inductances est de servir de bouchon afin d'éviter que le signal dynamique traversant le transformateur atteigne les alimentations. Des condensateurs supplémentaires sont alors généralement placés entre chacune des bornes 4 et 5 et l'inductance L1, respectivement le condensateur C2. Ces condensateurs empêchent que la composante continue fixée côté mode différentiel n'atteigne la borne de mode commun 3.

Un transformateur à changement de mode se caractérise essentiellement par quatre paramètres mesurés en chargeant les différents accès avec des impédances normalisées de 50 ohms.

Un premier paramètre concerne les pertes d'insertion différentielles (insertion loss) correspondant à l'atténuation en transmission entre la borne de mode commun et les deux bornes différentielles. On considère généralement ce paramètre comme bon si les pertes sont inférieures à 1 dB.

Un deuxième paramètre est la différence d'amplitude d'une voie par rapport à l'autre (amplitude imbalance) qui correspond à la différence entre les pertes d'insertion d'une voie par rapport à l'autre. Dans un transformateur idéal, c'est-à-dire parfaitement équilibré et sans perte d'insertion, le signal se divise en deux pour les deux ports différentiels et on obtient donc sur chaque voie -3 dB par rapport au signal de mode commun. La différence d'amplitude est alors nulle. On considère que le paramètre de différence d'amplitude est bon s'il est compris entre -0,5 dB et 0,5 dB. Ce paramètre de différence d'amplitude est particulièrement important dans la mesure où le signal est généralement exploité côté mode différentiel par différence des signaux afin d'annuler les perturbations éventuelles.

Un troisième paramètre est la différence de phase (phase imbalance) qui mesure l'écart entre la différence de phase des deux accès différentiels par rapport aux 180 degrés souhaités dans le cas idéal. On considère que la différence de phase est bonne si elle est comprise entre -5° et 5°.

Un quatrième paramètre est la perte en réflexion (matching ou return loss) qui correspond à l'adaptation d'impédance sur les accès de mode commun et de mode différentiel. Ce dernier paramètre est évalué en fonction des circuits connectés à chaque extrémité du transformateur et est considéré comme acceptable s'il est inférieur à -15 dB.

Tous les paramètres ci-dessus sont évalués pour différentes fréquences de signaux et sont en fait donnés pour une bande de fréquences de fonctionnement du transformateur (operating frequency range) autour d'une fréquence centrale.

Un inconvénient des transformateurs à changement de mode à éléments localisés classiques est qu'ils présentent généralement un mauvais paramètre de différence d'amplitude. Plus précisément, la bande de fonctionnement dans laquelle ce paramètre est acceptable (compris entre -0,5 et 0,5 dB) est très réduite.

Le brevet américain N° 6 052 039 décrit un balun à éléments localisés constitué de plusieurs filtres en π et en T de type LCL ou CLC entre l'accès de mode commun et chaque accès de mode différentiel, afin d'élargir la bande passante du balun. La réalisation d'un tel balun sous forme d'éléments localisés est particulièrement encombrante en raison du nombre de filtres en π et en T et, notamment, prend considérablement plus de place qu'un balun de type de celui représenté en figure 1.

Le brevet américain N° 5 148 130 décrit également un balun large bande à éléments localisés, réalisé au moyen de plusieurs structures en π de type LCL ou CLC entre l'accès de mode commun et les accès de mode différentiel.

Dans les deux documents ci-dessus, on cherche à élargir la bande de fréquences du balun en multipliant le nombre de cellules de filtrage. Typiquement, les bandes passantes recherchées par ces baluns sont de plusieurs centaines de mégahertz.

Résumé de l'invention

La présente invention vise à améliorer les transformateurs à changement de mode à éléments localisés faible bande (inférieure à 100 MHz) et notamment le paramètre de différence d'amplitude.

L'invention vise également à proposer un tel transformateur à changement de mode qui puisse s'intégrer sans prendre plus de place qu'un transformateur faible bande classique du type de celui représenté en figure 1.

Pour atteindre tout ou partie de ces objets ainsi que d'autres, la présente invention prévoit un transformateur à changement de mode à éléments localisés comprenant :

   entre une première borne d'accès de mode commun et une première borne d'accès de mode différentiel définissant une première voie, deux cellules LC constituées chacune d'une inductance intercalée sur la première voie et d'un condensateur reliant une extrémité de cette inductance à la masse ; et entre ladite première borne d'accès de mode commun et une deuxième borne d'accès de mode différentiel définissant une deuxième voie, deux cellules LC constituées chacune d'un condensateur intercalé sur la deuxième voie et d'une inductance reliant une des électrodes de ce condensateur à la masse, les inductances respectives des deux cellules de chaque voie étant réalisées sous forme d'inductances à point milieu dont les portions respectives d'une même voie sont couplées par une réalisation dans plusieurs niveaux de métallisation superposés.

Selon un mode de réalisation de la présente invention, les fréquences centrales des cellules d'une même voie sont choisies pour encadrer la fréquence centrale de la bande de fonctionnement souhaitée pour le transformateur complet.

Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

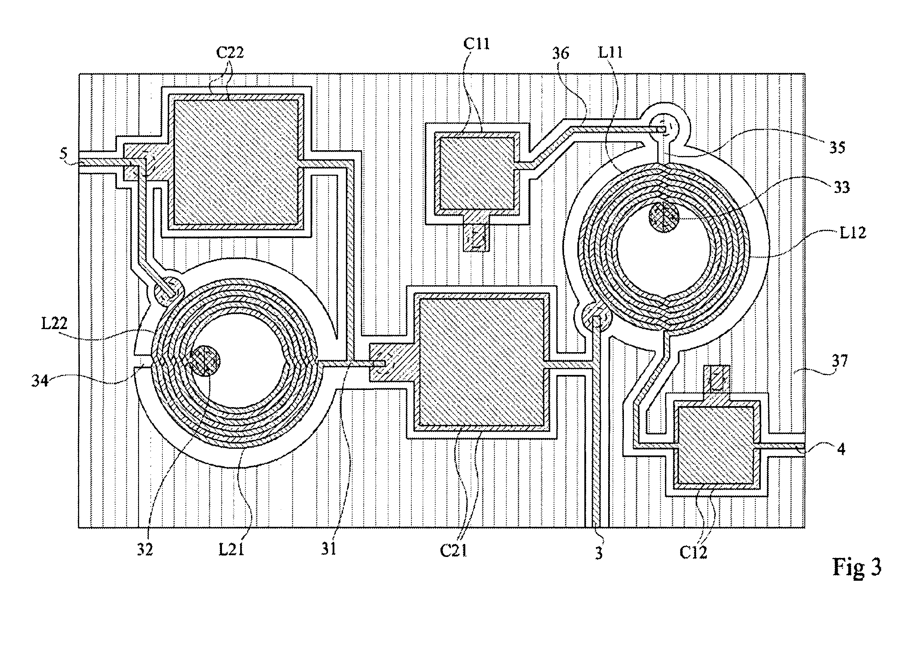

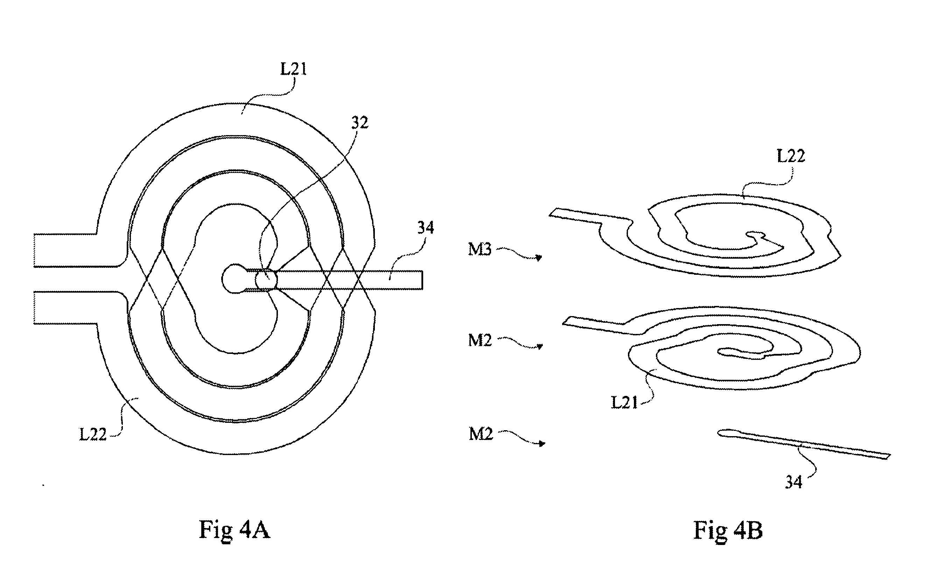

   la figure 1 décrite précédemment représente un exemple classique d'un transformateur à changement de mode faible bande à éléments localisés ; la figure 2 représente le schéma électrique d'un mode de réalisation d'un transformateur à changement de mode selon la présente invention ; la figure 3 est une vue schématique de dessus d'un exemple de réalisation du balun de la figure 2 sous forme intégrée ; et les figures 4A et 4B représentent, respectivement vu de dessus et en perspective éclatée, un exemple de réalisation d'une inductance à point milieu utilisée dans un balun selon l'invention.

Description détaillée

Les mêmes éléments ont été désignés par les mêmes références aux différentes figures. Pour des raisons de clarté, seuls les éléments qui sont nécessaires à la compréhension de l'invention ont été représentés aux figures et seront décrits par la suite. En particulier, les circuits d'amenée de composantes continues du mode différentiel n'ont pas été illustrés et ne font pas l'objet de la présente invention. De même, les circuits connectés côté mode commun (généralement une antenne) et côté mode différentiel n'ont pas été représentés, l'invention s'appliquant quelle que soit la destination du transformateur à changement de mode pourvu que cette application soit compatible avec ses fréquences de fonctionnement.

Selon un mode de réalisation de la présente invention, on prévoit, sur chaque voie séparant l'accès de mode commun à un des accès de mode différentiel, deux cellules LC de structure identique entre elles et de structure différente de celles des cellules LC de l'autre voie.

Une autre caractéristique d'un mode de réalisation préféré de la présente invention est de réaliser les quatre inductances du transformateur à changement de mode sous la forme de deux inductances à point milieu dont les portions respectives sont empilées deux à deux.

Une autre caractéristique d'un mode de réalisation préféré de la présente invention est que les cellules LC de chaque voie sont dimensionnées pour que leurs fréquences centrales respectives soient situées de part et d'autre de la fréquence centrale souhaitée pour le transformateur à changement de mode complet.

A la différence des transformateurs large bande connus des documents 5 148 130 et 6 052 039, les cellules prévues par l'invention sont des cellules LC exclusivement et non des structures en π ou en T de type LCL ou CLC.

Contre toute attente, le fait de prévoir, sur chaque voie, deux cellules LC en série s'apparentant à des cellules de filtrage d'un même type mais d'un type différent des cellules de filtrage de l'autre voie, est compatible avec l'obtention d'un transformateur à changement de mode faible bande. On pensait jusqu'alors, et notamment des brevets américains cités précédemment 5 148 130 et 6 052 039, qu'associer plusieurs cellules de même type en série conduisait forcément à un transformateur large bande.

Une autre difficulté est de respecter la différence de phase de 180° entre les voies. En effet, si deux filtres respectivement passe-haut et passe-bas du premier ordre placés sur les voies respectives du transformateur conduisent à des déphasages respectifs de +90° et -90° (figure 1), le fait de passer à des filtres du deuxième ordre conduirait à des déphasages respectifs de +180° et -180°, entraînant alors un déphasage nul entre les voies différentielles, donc à la perte de l'effet balun.

Selon un mode de réalisation de la présente invention, on préserve à la fois la différence de phase entre les deux voies et le caractère faible bande du balun en décalant les fréquences respectives de chaque cellule d'une même voie par rapport à la fréquence centrale, de telle sorte que ces fréquences l'encadrent et que la somme des deux déphasages à la fréquence centrale et dans toute la bande souhaitée pour le transformateur, est de 180° entre les voies.

La figure 2 représente le schéma électrique d'un transformateur à changement de mode selon un mode de réalisation de la présente invention.

On y retrouve, comme dans un transformateur à changement de mode à éléments localisés classique, une borne 3 d'accès de mode commun et deux bornes 4 et 5 d'accès de mode différentiel.

Sur une première voie (entre les bornes 3 et 4), on prévoit deux cellules 11 et 12 LC de même type (réalisant deux ordres de filtres passe-bas). La cellule 11 comprend une inductance L11 et un condensateur C11. La cellule 12 comprend une inductance L12 et un condensateur C12. Les inductances L11 et L12 sont donc en série entre les bornes 3 et 4, le condensateur C11 relie le point milieu de cette association en série à la masse et le condensateur C12 relie la borne 4 à la masse.

Côté deuxième voie (entre les bornes 3 et 5), on prévoit deux cellules 21 et 22 du type opposé aux cellules de la première voie. Ces deux cellules réalisent ici des ordres de filtre passe-haut. La cellule 21 comporte un condensateur C21 et une inductance L21. La cellule 22 comporte un condensateur C22 et une inductance L22. Les condensateurs C21 et C22 sont donc en série entre les bornes 3 et 5. L'inductance L21 relie le point milieu de cette association en série à la masse et l'inductance L22 relie la borne 5 à la masse.

Comme dans un transformateur à changement de mode classique, des circuits additionnels apportant des composantes continues (tensions de polarisation) côté mode différentiel peuvent être prévus. Toutefois, la cellule 22, bien que comportant une inductance et un condensateur dans un arrangement proche de celui d'un circuit de polarisation (inductance de choc reliée à une tension de polarisation et condensateur de blocage du continu vers le mode commun), en diffère par le fait qu'aucune tension de polarisation continue n'est appliquée à l'inductance L22 et par les valeurs fortement différentes des composants. Pour une fréquence centrale donnée, la valeur du condensateur d'un circuit de polarisation est de l'ordre de dix fois plus élevée que celle du condensateur C22 et son inductance est au moins trois fois plus grande que l'inductance L22.

De préférence, pour dimensionner les condensateurs des inductances, on part de valeurs obtenues en utilisant les conditions et formules suivantes et l'on optimise ces valeurs en utilisant, par exemple, des modèles réels à partir d'outils de simulation classiques.

On part de valeurs d'inductances L11 et L12 identiques et de valeurs d'inductances L21 et L22 identiques respectivement. De même, on part de valeurs de condensateurs C12 et C11 identiques et de valeurs de condensateurs C21 et C22 identiques respectivement. On calcule les valeurs L et C de ces composants identiques pour chaque voie en utilisant les formules suivantes :

$$L = \frac{\sqrt{Z1Z2}}{\omega} \quad \text{et} \quad C = \frac{1}{\omega\sqrt{Z1Z2}},$$

où ω représente la pulsation à la fréquence centrale de la bande de fonctionnement souhaitée, où Z1 désigne l'impédance de l'accès de mode commun et où Z2 représente l'impédance de la sortie différentielle.

La détermination des valeurs à donner aux composants d'un transformateur à changement de mode à éléments localisés selon l'invention est à la portée de l'homme du métier à partir des indications fonctionnelles et des conditions données ci-dessus, ces valeurs étant bien entendu à adapter, par exemple au moyen d'outils de simulation courants, en fonction du procédé de fabrication et autres paramètres (matériaux, etc.) qui conditionnent classiquement le fonctionnement d'un balun par rapport à un cas idéal.

A titre d'exemple particulier de réalisation, les inventeurs ont réalisé un transformateur à changement de mode avec les valeurs approximatives suivantes :

    L11 = 10,2 nanohenrys ;
    L12 = 12,4 nanohenrys ;
    L21 = 18,3 nanohenrys ;
    L22 = 22,6 nanohenrys ;
    C11 = 2,1 picofarads ;
    C12 = 1,0 picofarad ;
    C21 = 5,6 picofarads ; et
    C22 = 2,7 picofarads.

Avec de telles valeurs, les fréquences de coupure respectives des cellules sont les suivantes :

    cellule 11 : 0,95 GHz ;
    cellule 12 : 1,4 GHz ;
    cellule 21 : 0,5 GHz ; et
    cellule 22 : 0,65 GHz.

Le transformateur à changement de mode obtenu présente, pour une bande de fréquences de fonctionnement comprise entre 820 et 920 MHz et une fréquence centrale de l'ordre de 870 GHz, les paramètres suivants :

    différence d'amplitude comprise entre -0,5 et 0,5 dB ;
    pertes d'insertion inférieures à 0,74 dB ;
    différence de phase comprise entre -2,3° et 0,78° ; et
    matching inférieur à -15,8 dB.

Ces paramètres sont donnés en tenant compte d'une tolérance de 10 % pour les condensateurs et de 5 % pour les inductances.

De tels paramètres sont à comparer avec les paramètres suivants qui seraient obtenus avec une structure classique du type de celle représentée en figure 1 :

    différence d'amplitude comprise entre -2 et 2 dB ;
    pertes d'insertion inférieures à 0,71 ;
    différence de phase comprise entre -2° et 1,1° ; et
    matching inférieur à -14 dB.

Un avantage de l'invention est donc d'améliorer considérablement la différence d'amplitude par rapport à une structure classique, sans nuire aux autres paramètres.

Le transformateur à changement de mode de la figure 2 est obtenu sans requérir un encombrement de surface plus importante qu'un transformateur classique (figure 1) en réalisant les inductances L11 et L12, respectivement L21 et L22, sous la forme d'une inductance à point milieu dont les deux portions sont empilées en utilisant trois niveaux de métallisation (un pour chaque portion de part et d'autre du point milieu et un pour reporter le point milieu à l'extérieur des enroulements).

On tire alors profit de la structure du transformateur de la figure 2 prévue par l'invention. En effet, les inductances L21, L22 ayant un point milieu à la masse et les inductances L11 et L12 ayant un point milieu connecté au condensateur C11, leur réalisation est compatible avec l'utilisation d'une inductance à point milieu à portions empilées.

Un tel mode de réalisation permet même de réduire la taille par rapport à celle d'un transformateur à changement de mode classique. En effet, grâce au couplage obtenu entre les deux portions de chaque inductance à point milieu, on multiplie par quatre la valeur d'inductance pour une longueur donnée et un nombre de spires identiques. A valeur d'inductance donnée, on réduit donc la longueur de la piste conductrice et/ou le nombre de spires. La réalisation en elle-même d'une inductance à point milieu dans trois niveaux conducteurs est connue. On pourra se référer, par exemple, à la demande de brevet américain N° 2003/0210122 de la demanderesse.

La figure 3 est une vue schématique de dessus d'un transformateur à changement de mode à inductances à point milieu selon un mode de réalisation de l'invention.

Cette figure est une vue de dessus d'une réalisation dans trois niveaux de métallisation séparés les uns des autres par des niveaux isolants (non ferromagnétiques). Pour simplifier, ces niveaux isolants n'ont pas été représentés.

Les inductances L11 et L12 sont réalisées par une structure à point milieu du type de celles décrites dans la demande américaine 2003/0210122 citée précédemment. Les inductances L21 et L22 sont également réalisées dans une structure d'inductance à point milieu de ce type. Les condensateurs C11, C12, C13 et C22 sont, de préférence, réalisés en utilisant les mêmes niveaux de métallisation que ceux dans lesquels sont formés des inductances ainsi que leurs pistes de reprise de point milieu, les couches isolantes séparant ces niveaux de métallisation constituant les diélectriques respectifs des différents condensateurs.

Comme il ressort de la figure 3, les points milieu 32 et 33 des inductances empilées respectives sont reliés par une piste conductrice respectivement 34 et 35 dans un troisième niveau de métallisation à l'extérieur de la structure de l'inductance correspondante, pour être connectés au condensateur C11 (piste 36) ou au plan de masse 37.

A la différence de la structure symétrique décrite dans la demande américaine 2003/0210122, on obtient des valeurs d'inductance différentes pour les inductances L11, L12, L21 et L22 respectivement en les prévoyant de longueurs différentes. En d'autres termes, les extrémités des enroulements L11 et L12 connectées respectivement aux bornes 3 et 4 ne sont pas diamétralement opposées dans la première structure d'inductance à point milieu. De même, les extrémités des inductances L21 et L22, respectivement connectées au point milieu 31 entre les condensateurs C21 et C22 et à la borne 5, ne sont pas diamétralement opposées dans la deuxième structure d'inductance à point milieu.

Le reste de la structure de la figure 3 est à la portée de l'homme de métier en particulier pour la réalisation des vias (symbolisés en pointillés) entre les différents niveaux de métallisation et les pistes de connexion des différents composants.

Une structure telle qu'illustrée à la figure 3 représente, avec les valeurs de l'exemple numérique donné précédemment, une surface de l'ordre de 1,5 mm 2 qui est à comparer avec une surface de 1,7 mm nécessaire pour réaliser avec des valeurs L1 = 11 nH, C1 = 2,8 pF, L2 = 10 nH, C2 = 3 pF un balun classique du type de celui représenté en figure 1.

Les figures 4A et 4B illustrent, respectivement par une vue de dessus et par une vue en perspective éclatée, un exemple de réalisation d'inductances à point milieu (par exemple L21 et L22) à partir de trois niveaux de métallisation M1, M2, M3 (figure 4B). Par exemple, l'enroulement L21 est réalisé dans le niveau M3, l'enroulement L22 dans le niveau M2 et la piste 34 sortant le contact de point milieu 32 vers l'extérieur dans le niveau M1. Pour simplifier, les niveaux isolants séparant les niveaux conducteurs n'ont pas été représentés et les enroulements L21 et L22 ont été supposés de mêmes longueurs. L'ordre des niveaux peut être différent. Par exemple, la piste 34 peut être formée dans le niveau intermédiaire M2 entre les niveaux M1 et M3 comportant alors les enroulements L21 et L22 (ou inversement).

Bien entendu, la présente invention est susceptible de diverses variantes et modifications qui apparaîtront à l'homme de l'art. En particulier, les dimensionnements respectifs des inductances et condensateurs du balun de l'invention dépendent de l'application et notamment de la fréquence de la bande passante choisie et sont à la portée de l'homme du métier à partir des indications données ci-dessus et des outils de modélisation classique.

## Revendications

1. Transformateur à changement de mode à éléments localisés comprenant :

entre une première borne (3) d'accès de mode commun et une première borne (4) d'accès de mode différentiel définissant une première voie, deux cellules LC (11, 12) constituées chacune d'une inductance (L11, L12) intercalée sur la première voie et d'un condensateur (C11, C12) reliant une extrémité de cette inductance à la masse ; et

entre ladite première borne d'accès de mode commun et une deuxième borne (5) d'accès de mode différentiel définissant une deuxième voie, deux cellules LC (21, 22) constituées chacune d'un condensateur (C21, C22) intercalé sur la deuxième voie et d'une inductance (L21, L22) reliant une des électrodes de ce condensateur à la masse, les inductances respectives des deux cellules de chaque voie étant réalisées sous forme d'inductances à point milieu dont les portions respectives d'une même voie sont couplées par une réalisation dans plusieurs niveaux de métallisation superposés.

2. Transformateur selon la revendication 1, dans lequel les fréquences centrales des cellules d'une même voie sont choisies pour encadrer la fréquence centrale de la bande de fonctionnement souhaitée pour le transformateur complet.

## Claims

1. A mode-switching transformer with localized components, comprising:

between a first common-mode access terminal (3) and a first differential-mode access terminal (4) defining a first path, first two LC cells (11, 12), each formed of an inductance (L11, L12) interposed on the first path and of a capacitor (C11, C12) connecting one end of this inductance to ground; and

between said first common-mode access terminal and a second differential-mode access terminal (5) defining a second path, second two LC cells (21, 22), each formed of a capacitor (C21, C22) interposed on the second path and of an inductance (L21, L22) connecting one of the electrodes of this capacitor to ground,

the respective inductances of the two cells of each path being made in the form of inductances with a midpoint having respective coupled portions of a same path formed in several superposed metallization levels.

2. The transformer of claim 1, wherein the central frequencies of a same path are selected to surround the central frequency of the operating band desired for the whole transformer.

## Patentansprüche

1. Ein Modus-Schalttransformator mit lokalisierten Komponenten, der Folgendes aufweist:

zwischen einem ersten Symmetrie- bzw. Gleichtaktzugangsanschluss (3) und einem ersten Differentialmodus- bzw. Gegentaktzugangsanschluss (4), die einen ersten Pfad definieren, erste zwei LC-Zellen (11, 12), die jeweils aus einer Induktanz (L11, L12), die in dem ersten Pfad zwischengeschaltet bzw. eingefügt ist, und aus einem Kondensator (C11, C12), der ein Ende dieser Induktanz mit Erde bzw. Masse verbindet, gebildet sind; und

zwischen dem ersten Gleichtaktzugangsanschluss und einem zweiten Gegentaktzugangsanschluss (5) eine zweiten Pfad definierend, zweite zwei LC-Zellen (21, 22), die jeweils gebildet sind aus einem Kondensator (C21, C22), der in dem zweiten Pfad eingefügt ist und aus einer Induktanz (L21, L22), die eine der Elektroden dieses Kondensators mit Masse verbindet, wobei die entsprechenden Induktanzen der zwei Zellen von jedem Pfad hergestellt sind in der Form von Induktanzen mit einem Mittelpunkt, wobei entsprechend gekoppelte Teile eines gleichen Pfades in mehreren überlagerten Metallisierungsebenen gebildet sind.

2. Transformator nach Anspruch 1, wobei die zentralen Frequenzen eines gleichen Pfades gewählt werden, um die zentrale Frequenz des Betriebsbandes zu umgeben, das für den gesamten Transformator gewünscht ist.

Fig 1

Fig 2

Fig 3

EP 1 659 686 B1

Fig 4B

L22

L21

34

M3

M2

M2

Fig 4A

34

32

L21

L22